(19)

Europäisches
Patentamt

European
Patent Office

Office européen
des brevets

(11) **EP 4 495 975 A1**

(12) **EUROPEAN PATENT APPLICATION**

(43) Date of publication:
**22.01.2025  Bulletin 2025/04**

(21) Application number: **24183046.2**

(22) Date of filing: **19.06.2024**

(51) International Patent Classification (IPC):
**H01J 37/304** (2006.01)     **H01J 37/317** (2006.01)

(52) Cooperative Patent Classification (CPC):
**H01J 37/3174; H01J 37/304;** H01J 2237/30433;
H01J 2237/31769; H01J 2237/31774;
H01J 2237/31796

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.06.2023  EP 23180357**

(71) Applicant: **IMS Nanofabrication GmbH
2345 Brunn am Gebirge (AT)**

(72) Inventors:
• **Spengler, Christoph
1150 Wien (AT)**
• **Naetar, Wolf
1080 Wien (AT)**
• **Leitner, Johannes
1120 Vienna (AT)**
• **Platzgummer, Elmar
1090 Wien (AT)**

(74) Representative: **Patentanwaltskanzlei
Matschnig & Forsthuber OG
Biberstraße 22
Postfach 36
1010 Wien (AT)**

(54) **DETERMINATION OF IMAGING TRANSFER FUNCTION OF A CHARGED-PARTICLE EXPOSURE APPARATUS USING ISOFOCAL DOSE MEASUREMENTS**

(57)     A method for determining parameters of an imaging transfer function (point spread function) is presented. With regard to a model that describes the imaging transfer function including a number of model parameters, a test substrate is exposed and developed using a test pattern (50) which comprises multiple sub-patterns (55) that are based on the same sub-pattern template but with varying control width of a feature in the template, such as the width of a line or a distance between lines. On the test substrate, isofocal dose measurements are performed using the structures thus formed on a test substrate with varying control and imaging parameters. The isofocal dose thus determined are utilized to determine the model parameters of the imaging transfer function.

Fig. 5D

**Description**

Field of the invention and description of prior art

The invention relates to pattern writing methods employed in charged-particle processing apparatuses, and more specifically to determining an imaging transfer function - such as a point spread function - of a charged-particle exposure apparatus during exposure of a target positioned in a target plane of said apparatus. Methods and apparatuses of this kind are used in reticle manufacturing or maskless direct-write lithography. The applicant describes such methods and apparatuses, for instance, in US 9,520,268, US 6,768,125, US 8,222,621 and US 8,378,320. In particular, the applicant has realized a 50keV electron multi-beam writer to realize leading-edge complex photomasks for 193nm immersion lithography, of masks for EUV lithography and of templates (1x masks) for imprint lithography. The system is called eMET (electron Mask Exposure Tool) or MBMW (multi-beam mask writer) for exposing 6" mask blank substrates.

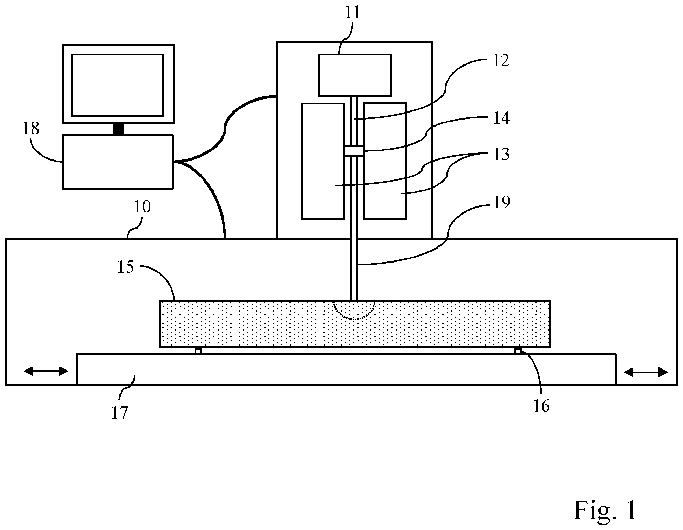

A typical implementation of the invention utilizes a charge-particle exposure apparatus as illustrated schematically in Fig. 1 (not to scale), which includes a charged particle illumination system 11 generating a charged particle beam 12, a projection optics system 13, a beam-shaping device or aperture array device 14 modifying the shape of the beam or the pattern transferred to the substrate, preferably by forming the beam into a plurality of sub-beams propagating in parallel ("multi-beam" 19). Furthermore, the apparatus includes an exposure chamber 10 containing a target 15 to be exposed (e.g. a resist-covered quartz photomask or silicon wafer) which is mechanically fixed with clamps 16 (or other types of mounts) to a moving stage 17. The exposure apparatus is controlled by a processing system 18. Further details about charged-particle exposure apparatuses can be found in the above-mentioned published patent documents.

The invention aims at certain improvements of the correction of the proximity effect in electron beam lithography, which is caused by the interaction of the electron beam and the resist and substrate employed for the writing process. In particular, the invention aims at a method to determine a point spread function that is suitable for use in proximity effect correction. Proximity effect correction (PEC), which adjusts the pattern to be exposed or its exposure dose amount to account for additional dose from backscattered electrons, is a well-established technique in electron beam lithography, see, for instance, US 5,241,185, US 6,815,693 or US 7,511,290.

For this purpose, it is known to model the electron-substrate interaction as an exposure intensity distribution function (or point spread function), which describes an imaging transfer function from a single element of a pattern definition device (which single element has minimal lateral extension, ideally point-like) to the target plane; this exposure intensity distribution function is then convolved with the pattern to obtain the dose distribution on the target.

For CoG (Chrome on Glass) or OMOG (Opaque MoSi on Glass) photomasks used in 193nm immersion lithography, a typical choice of point spread function is a two-component Multi-Gaussian

$$F_{MG2}(r) = \frac{1}{1+\eta}\Big(G_\alpha(r) + \eta G_\beta(r)\Big),$$

where $G_\alpha$ is a forward-scattering component with range $\alpha$ (in the order of 20nm) and weight normed to 1 and $G_\beta$ a backscattering component with range $\beta$ (in the order of 10μm) with weight or backscattering ratio $\eta$ (with typical values in the range of 0.3 - 0.8) and

$$G_\omega(r) = \frac{1}{\pi\omega^2}\exp\left(-\frac{r^2}{\omega^2}\right),$$

a (rotationally symmetric) Gaussian with integral normed to 1.

For reticles used in Extreme Ultraviolet (EUV) lithography in particular, a two-Gaussian model is usually not sufficient, due to more complex backscattering effects generated by the thick Mo/Si multilayer structures found on EUV mask blanks (see H. Tanabe et al. in Proc. SPIE Vol. 7748, Photomask and Next-Generation Lithography Mask Technology XVII, 774823; available at https://doi.org/10.1117/12.862641). Instead, a model with more Gaussian components is suitable. For instance, a triple Gaussian model

$$F_{MG3}(r) = \frac{1}{1+\nu+\eta}\Big(G_\alpha(r) + \nu G_\gamma(r) + \eta G_\beta(r)\Big),$$

is utilized, where $G_\gamma$ is a mid-range scattering component with range $\gamma$ (typically in the order of 400nm) with corresponding weight $\nu$ (around 0.2).

One prior-art approach determines the point spread function by imposing and fitting an exposure model (which may include development and etch effects) to values of critical dimensions (CDs) generated and measured for variable dose or pattern (see, for instance, P. Hudek et al. in J. Micro/Nanopattern. Mats. Metro. 20(4) 041402; available at https://doi.org/10.1117/1.JMM.20.4.041402).

Furthermore, in prior art, the use of an isofocal dose measurement has been suggested to determine and compare process windows in electron beam lithography (see e.g. K. Keil et al. in Microelectronic Engineering, Volume 85, Issues 5-6, pp. 778-781; available at https://doi.org/10.1016/j.mee.2008.01.042); however, this approach does not lend itself to determining a point spread function, in particular in relation to proximity effect correction.

Summary of the invention

The aim of the method according to the invention below is the determination of a point spread function (or parameters thereof), or more generally of an imaging transfer function, in particular in relation to use in proximity effect correction in electron beam lithography. The method approaches the problem in terms of a (mathematical or numerical) model that describes the imaging transfer function through a number of model parameters, by exposing and developing a test substrate (which may also be a set of substrates if preferred) using a test pattern which comprising multiple sub-patterns based on the same sub-pattern template but with varying control width of a feature in the template, such as the width of a line or a distance between lines. On this test substrate a corresponding number of isofocal dose measurements are performed on the test structures thus formed with varying control and imaging parameters (where a control width of a feature in the template is varied to influence the backscattering a feature of interest is subjected to). Then, the isofocal dose measurements are utilized to determine the imaging transfer function (point spread function).

More specifically, the invention proposes a method for determining an imaging transfer function, such as in particular a point spread function, of a charged-particle exposure apparatus during exposure of a target positioned in a target plane of said apparatus, said imaging transfer function describing the distribution of dose or energy generated at the target plane resulting from a single active element (such as a single aperture opening, or ideally a point-like opening) in a pattern definition device of the charged-particle exposure apparatus when said single active element is imaged to a substrate in the charged-particle exposure apparatus, wherein the method comprises the following steps:

i. providing a model of the imaging transfer function, where said model includes at least one function parameter to be determined;

ii. selecting a set of imaging properties (relating to the charged-particle exposure apparatus), which are adjustable through modifying pre-defined imaging parameters of the charged-particle apparatus; the imaging properties will typically include a beam blur and/ or a beam focus, but do not include a base exposure dose describing an overall intensity (in the sense that it is the intensity integrated over the target plane) of the imaging transfer function;

iii. exposing, using the exposure apparatus, a test substrate (which may be a single substrate or a set of individual test substrates) with a test pattern and developing (and optionally further processing, e.g. etch) the test substrate to produce a test structure on said at least one test substrate,

wherein the test pattern comprises a plurality of sub-patterns each of which is a copy of a sub-pattern template modified according to at least one control parameter, said at least one control parameter varying across the sub-patterns of the plurality of sub-patterns within a defined parameter range, and
wherein the test pattern is exposed to the test substrate a number of times with varying values of the base exposure dose and at least one imaging parameter of the charged-particle apparatus, to produce a number of test pattern copies on the substrate (and as a result, each of the number of test pattern copies may be associated with a respective/ different instance of imaging parameters),

the test structure thus produced comprising a plurality of sub-structures, each sub-structure being associated with specific values of imaging parameters, the base exposure dose, and said at least one control parameter;

iv. evaluating the sub-structures with respect to at least one measurable quantity, including a critical dimension of features in the sub-structure;

v. determining, for each value of the at least one control parameter, the variation of said at least one measurable quantity between the sub-structures as a function of the imaging parameters, and determining, from said variation, a respective value of isofocal dose where the variation is minimally variant with respect to the changes in the imaging parameters,

vi. calculating, using the values of isofocal dose determined in step v as function of the at least one control parameter, the at least one function parameter of the imaging transfer function.

In particular, in the case of a point spread function (PSF), the imaging parameters include a global dose or a maximal dose of exposure and/or the blur of the PSF; and the measurable quantity is e.g. a line width of specific lines in the sub-structures produced. Furthermore, in many embodiments of the method according to the invention also the additional parameter of isofocal dose can be determined. Examples for parameters of a PSF are parameters describing the "geometrical" shape and/or range of the PSF, such as the "range" parameters $\alpha$, $\beta$, $\gamma$ in the case of a Multi-Gaussian as mentioned above.

Compared to prior-art methods as mentioned above, the method offers several advantages. First, it allows for a degree of decoupling of electron-resist interactions (modelled with the point spread function) and processing effects (such as development and etch bias or loading). This is since isofocal dose measurements according to the invention are performed by modulating optical parameters for a constant pattern, leading to relatively narrow range of exposed CDs for each isofocal dose measurement, thus establishing a relatively constant etch and development regime. In comparison, known methods based on fitting the point spread function to line measurements typically utilize features in a wide range of feature sizes (and pattern density) in a single fit, which inevitably incorporates processing effects into the point spread function, thus having a detrimental influence on the accuracy of the determined point spread function. Furthermore, for patterns that are sufficiently large as compared to the forward scattering range $\alpha$, the isofocal dose (of the pattern) will depend only on the amount and range of backscattering while being independent of the forward scattering range. The inventors noted that this allows, in the context of the present invention, determination of backscattering parameters in isolation, usually without having to determine the forward scattering range. Values of critical dimensions for non-isofocal dose, as well as the change of CD under dose variations, in contrast, depend strongly on the forward scattering range $\alpha$ (depending on dose and/or background), which is why known methods of the art typically have to determine the full viable range of parameters of the point spread function. Consequently, the invention allows a determination of the isofocal dose and other PSF parameters at faster speed and reduced computational complexity.

In particular, in many embodiments of the invention the imaging transfer function is a point spread function describing the distribution of absorbed energy in a resist layer of a resist-covered target positioned at the target plane in response to a particle beam generated by means of a single active element, and the model of the point spread function may be implemented to account for charged particle scattering in the target. In this case, it can be advantageous to have the sub-structures exposed in step ii with different values of maximal exposure dose and blur of imaging. Moreover, the measurable quantity in steps iv and v may include a critical dimension of a feature of interest in the sub-structures. Furthermore, many embodiments of the invention may include the determination of an isofocal dose or a parameter corresponding thereto, where the isofocal dose represents the dose value at which the measured critical dimension of the exposed pattern is invariant under a change of beam blur. In particular, the method will typically include determining the isofocal dose (or a parameter corresponding thereto), and the isofocal dose can then be used in step vi for the calculation of the function parameter(s) of the imaging transfer function. It should be noted that the isofocal dose will usually be a function of some of the control and imaging parameters, and in such a case the isofocal dose will vary along the stationary parameter course; thus, the calculation of the parameter(s) of the imaging transfer function may also include the dependence of the isofocal dose from certain parameters, such as the pattern density or a control width of line spacings. Furthermore, as a simple yet efficient way to implement the different values of beam blur, these may be generated by physically defocusing the beam by means of modulation of appropriate electrostatic voltages of lens and/or multi-pole lens components of an imaging system of the charged-particle exposure apparatus, and/or by modulating the pattern to emulate an increased blur. The modulation of the pattern can be done, e.g., by convolution with a kernel, or variation of a vector pattern (for instance in a VSB writer) along a coordinate, which can be done to obtain a gentle transition between pattern and surrounding regions.

Furthermore, the method may be advantageously include a fit with regard to a model calculation based on a mathematical representation. Thus, before step vi, as an additional step there may be calculating, in terms of the model provided in step i and the at least one function parameter, a model calculation (i.e., a mathematical representation) of said at least one measurable quantity as a function of said subset of the imaging and control parameters and determining the values of the parameters of said subset where said model calculation predicts said at least one measurable quantity to be stationary with respect to said parameters; and then step v includes performing a least-squares fit of said model calculation to stationary parameter course to obtain final parameters of the imaging transfer function. Preferably this fit may be performed by finding an optimal value of an evaluation function including a weighted sum of squares of differences between the values of parameters in the model calculation and the stationary parameter course. Moreover, in order to improve the stability and convergence of the fit procedure, it may be useful to augment the evaluation function with a regularization term, which including the first and/or second radial derivatives of the imaging transfer function and/or the magnitude (L2) or sum of absolute values of a vector of imaging transfer functions (L1). The fit may be performed by performing a least-squares fit in order to obtain the parameter(s) of the imaging transfer function. In typical embodiments of the invention, the imaging transfer function is modeled as a radially symmetric piecewise polynomial function; a radially symmetric Multi-Gaussian; a weighted sum thereof; or a weighted combination thereof. For instance, the imaging transfer function may include a Multi-Gaussian comprising at least one mid-range component having a width between 200nm and $2\mu m$.

A further aspect of the invention is directed at an exposed substrate comprising a test structure (as developed or produced by the method of the invention in step iii, based on the model/parameters provided in steps i and ii) on a test substrate, the test structure comprising a plurality of sub-structures that have been exposed in the mentioned charged-particle exposure apparatus, where these sub-structures are formed using copies of the same underlying sub-pattern template modified according to a control parameter varying across the sub-patterns. Preferably, the substrate includes multiple sub-structures which have been formed in the charged-particle exposure apparatus by applying respective values of imaging parameters, which are different between each of said multiple sub-structures. Suitable examples for sub-pattern templates are, for instance,

a single line, wherein the control parameter is the width of line;
a triple line structure comprising a center line surrounded by two outer lines, wherein the control parameter is the width of the two outer lines;
a triple line structure comprising a center line surrounded by two outer lines, wherein the control parameter is the distance of the two outer lines from the center line;
or a combination of thereof.

In these cases the width of the single line or center line, respectively, may advantageously be used as the measurable quantity in the resulting sub-structure.

Brief description of the drawings

In the following, the present invention is illustrated by several embodiments described below in more detail with reference to the attached drawings. It is emphasized that the embodiments shown here are of illustrative character and are not to be construed as limiting the scope of the invention. The drawings schematically show:

Fig. 1 a schematical drawing of a lithography apparatus in longitudinal sectional view;

Fig. 2A and 2B illustrate the concept of isofocal dose for the example of a 50 nm line, with Fig. 2A showing a continuous profile and Fig. 2B showing a pixel-based profile;

Fig. 3A and 3B illustrate the procedure of determining an isofocal dose using Bossung plots, with Fig. 3A showing an example using a continuous profile and variation of height of beam focus $\Delta Z$, and Fig. 3B showing an example for evaluating pixel-based profiles with varying pixel-blur $\sigma$;

Fig. 4 is a flow chart of the steps of the method according to an embodiment of the invention;

Fig. 5 shows various examples of test patterns containing multiple sub-patterns, namely, Fig. 5A a test pattern containing a plurality of isolated lines having variable design width, Fig. 5B a test pattern wherein the sub-pattern templates have variable control widths of the outer two lines, and Fig. 5C a test pattern wherein the sub-pattern templates have variable distances between the central and outer lines; Fig. 5D shows a test pattern example including an array layout according to varying imaging and control parameters;

Fig. 6A shows a set of cubic B-Spline functions as base functions for modeling a PSF behavior;

Fig. 6B shows an example of combining the spline functions to fit an exemplary function;

Fig. 7 depicts the effect of a dose background onto the profile of a line edge;

Fig. 8 depicts the isofocal dose as a function of the unit dose background $b$;

Fig. 9 illustrates several examples of behavior of the isofocal dose as function of the line width; and

Fig. 10 illustrates a test of reproducibility of the parameters determined from the fitting procedure according to the invention.

## Detailed description of embodiments of the invention

The detailed discussion given herein is intended to illustrate the invention and exemplary embodiments thereof, as well as further advantageous developments. It will be evident to the skilled person to freely combine several or all of the embodiments and aspects discussed here as deemed suitable for a specific application of the invention. Throughout this disclosure, terms like "advantageous", "exemplary" or "preferred" indicate elements or dimensions which are particularly suitable (but not essential) to the invention or an embodiment thereof, and may be modified wherever deemed suitable by the skilled person, except where expressly stated otherwise. It will be appreciated that the invention is not restricted to the exemplary embodiments discussed in the following, which are given for illustrative purpose and merely present suitable implementations of the invention.

In particular, even though the invention can be used in combination with virtually any charged particle lithographic apparatus, it will be discussed in the exemplary context of electron-beam devices for lithographic mask manufacturing. In particular, in the lithography apparatus of Fig. 1 the calculation and correction methods described hereinafter may suitably be performed in the processing system 18 of the lithography apparatus and/or any other control system for processing the data and controlling the writing process on a substrate (the terms substrate and target are used interchangeably herein). Further details about multi-beam charged-particle tools can be found in US 9,520,268, US 6,768,125, US 8,222,621 and US 8,378,320 and references cited therein, which are all herewith included by reference as part of the disclosure.

The inventors suggest a novel method to determine an imaging transfer function, which is illustrated below relating to an example of a multi-component point spread function (PSF) in electron-beam lithography, using for instance a Multi-Gaussian PSF as introduced above, based on measurements of the isofocal dose for a test pattern containing a range of sub-patterns.

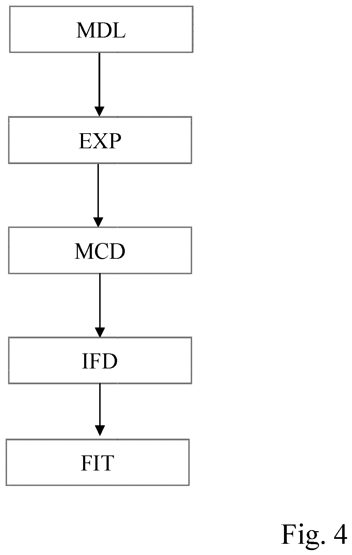

The flow-chart of Fig. 4 illustrates the method according to one embodiment of the invention. In a preliminary step MDL, the method starts by defining or selecting a suitable model of the PSF, which also determines the relevant parameters (and, where required, the ranges within which the parameters may vary). Typically, the model will be a mathematical description of the PSF, for instance in terms of a Multi-Gaussian PSF, where the parameters are the ranges and relative weights. Alternatively, the model may also be represented as a set of "knots" located at specific points on a one-dimensional coordinate (such as the radius with respect to the center of the PSF distribution) or the two-dimensional spatial plane, and then the PSF may be interpolated between these knots, for instance by linear interpolation or using splines. In step EXP, a test pattern comprising a number of sub-patterns comprising several features of interest having different control dimensions (for instance lines of variable width), corresponding to control parameters of the invention as claimed, is exposed with the charged particle exposure apparatus, employing a resist and substrate of specific properties (which are not part of the invention) and developed to produce a test substrate. It is noted that, herein, "developing" a substrate is meant to include all processing steps that are required to obtain a substrate which allows measurement of quantities of interest such as the critical dimension on the substrate. During the exposure process varying imaging parameters, for instance varying exposure dose and beam blur, are used for the various sub-patterns, thus producing a plurality of sub-structures in which the respective features are reproduced with variations depending on the respective imaging and control parameters. Then, in step MCD, the sub-structures thus produced are examined, measuring one or more quantities, in particular the critical dimension of the features of interest of the structures. Subsequently, in a first post-processing step IFD, the isofocal dose for each sub-pattern (more precisely, for the feature of interest in the sub-pattern) is determined from the measurements of critical dimension; more generally, this step IFD determines a stationary parameter set of the imaging parameters. Finally, in a second post-processing step FIT, a PSF modelling the interaction of electron beam and target is deduced from the range of isofocal doses.

## Test patterns

This section discusses several examples of test patterns which each comprise a set of respective sub-patterns suitable for the invention, with emphasis on lines of variable width and distance; it is to be noted, however, that the concepts introduced by the inventors can readily be translated to other types of test patterns such as dots/contacts/rectangles, or even more complex patterns.

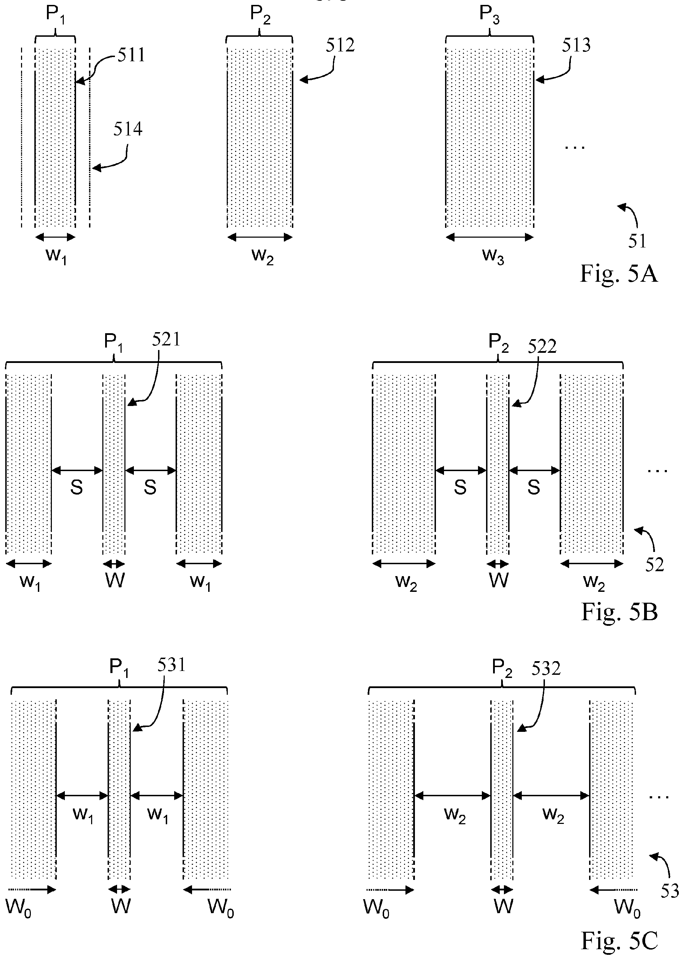

Fig. 5A illustrates one suitable embodiment of a test pattern 51, containing a plurality of isolated lines 511, 512, 513 of variable design width $w_1, ..., w_N$, which respectively realize sub-patterns $P_1, ..., P_N$ (only three sub-patterns are shown in Fig. 5A). In this case, each sub-pattern is a variant of an underlying sub-pattern template which comprises a single line. Each sub-pattern will result in a respective sub-pattern, for instance the sub-pattern $P_1$ might produce a sub-structure, shown in Fig. 5A overlaid as two contour lines 514. Here, the line width of the sub-pattern 514 (the difference between design width and exposed line width is shown exaggerated for clarity) is the critical dimension of interest (which serves as a measurement reference to determine the backscattering generated by the line itself), whereas the design

width $w_1, ..., w_N$ of the lines represents the control width, which in this case may be interpreted as controlling the amount of backscattering.

Fig. 5B illustrates a test pattern 52 of another suitable embodiment which provides variants of a sub-pattern template containing a triple of lines, reproduced as multiple sub-patterns $P_1, ..., P_N$ (only two of the sub-patterns are shown in Fig. 5B). In each triple, the center line 521, 522 is designed with a fixed line width W (preferably in the order of 3 forward-scattering ranges, e.g. 80 nm), and the outer two lines have variable control widths $w_1, w_2, ..., w_N$ (the widths $w_i$ for $i > 2$ are not shown), the outer lines spaced at a fixed distance S apart from the center line. The critical dimension of interest, used to determine the point spread function, is the width of the central line as exposed;. Thus, the center lines 521, 522 are the features of interest, whereas the outer lines serve as (backscattering) generators of dose background for the respective feature of interest. The pattern is, preferably, designed symmetrically so as to ensure equal dose background on the left and right edges of the center line. The advantage of this approach is the uniformity of field of view when measuring the central line via CD-SEM, which may facilitate more stable measurements.

In Fig. 5C, another suitable test pattern 53 is shown (again, only two of the sub-patterns are shown in the drawing). In this case, the underlying sub-pattern template contains a triple of lines at fixed widths but at varying distances. Thus, the test pattern includes sub-patterns $P_1, ..., P_N$ realized as triples of lines, respectively, of which the center line 531, 532 is the feature of interest, i.e., the exposed critical dimension as measured serves as a reference to determine the isofocal dose, and the two outer lines are background generators. In this variant, the widths of the center line $W$ (e.g. in the order of 3 forward-scattering ranges) and the width of the outer lines $W_0$ (which is preferably at least 3 backscattering ranges, in order to ensure a fully saturated point spread function) is fixed; to vary the amount of backscattering at the central line edge, the spaces between the central line and the outer lines, which serve as background-generating blocks, are realized with varying widths $w_1, ..., w_N$, which represent the control widths in this pattern 53.

In all variants, the length of the lines should favorably be longer than 3 backscattering ranges, which simplifies the model calculations in that they can be performed one-dimensionally in this case. The variable widths and spaces should favorably correspond to the range of the point spread function to be determined, and a higher measurement density of control widths typically leads to more accurate results. To determine the isofocal dose for each sub-pattern, it may be necessary to expose multiple copies of the sub-patterns with variable configurations of dose and blur. Furthermore, it may increase the accuracy to obtain several such measurements from the features of interest (e.g. on different positions along each feature of interest), which can be averaged to ensure low measurement noise or, in the case of a multi-beam exposure apparatus, sample over the beam field (over which the blur may vary).

Also, several types of sub-patterns (e.g. of the types shown in Figs. 5A, 5B, and 5C and/or others) may be combined, e.g. by fitting the point spread function to the combined data relating to the different sub-pattern types.

In all variants the distance between the sub-patterns $P_1, ..., P_N$ will advantageously be chosen sufficiently large so as to avoid mutual influence by backscattering or other unwanted effects.

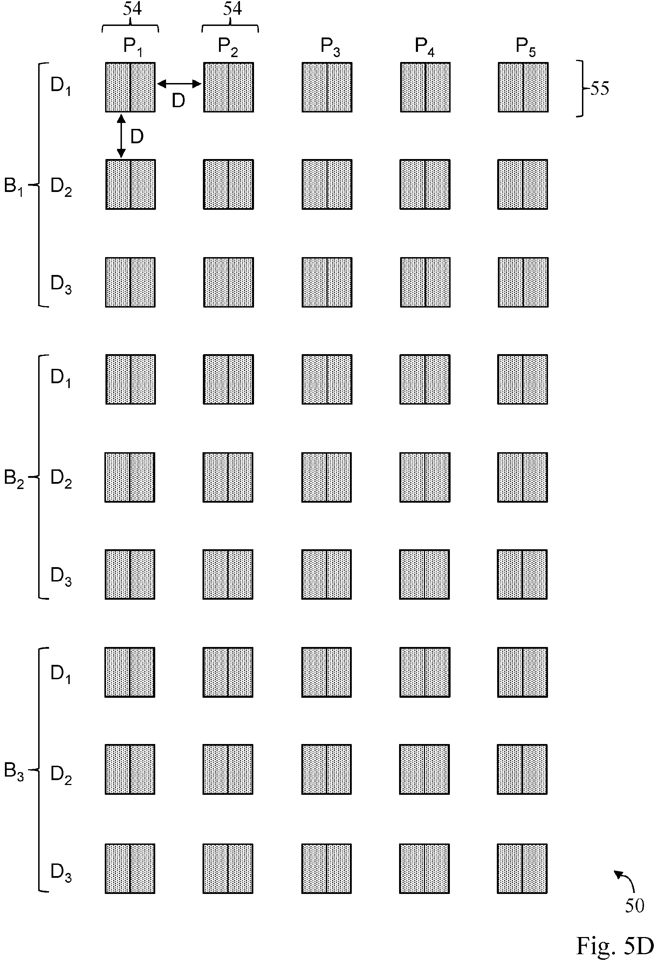

Fig. 5D illustrates an exemplary test pattern 50, which includes a layout that allows exposures of multiple sub-patterns at varying exposure parameters. The layout comprises a plurality of sub-patterns $P_1, ..., P_5$, which each contain e.g. a triple line pattern as shown in Fig. 5B or 5C with a respective control width $w_1, ..., w_5$, varying across the sub-patterns of e.g. a row 55. The sub-patterns are preferably arranged according to an array in which the sub-patterns $P_1, ..., P_5$ form columns 54 in which the sub-patterns have all the same control width, and within each column the sub-patterns are exposed with different imaging parameters, in this case different dose values $D_1, ..., D_3$ (e.g. -10%, 0%, and +10% relative to a predefined default dose) and different values of blur $B_1, ..., B_3$ (e.g. -2μm, 0μm and +2μm beam focus relative to a reference focus, for instance the focus of the feature of interest). Preferably, these imaging parameters are allotted to the sub-patterns such that the parameters are constant within each of the rows 55 of the layout; the respective value set for each column can be seen from Fig. 5D. The skilled person will appreciate that Fig. 5D shows a simplified embodiment, and in practice, the layout may have to incorporate more values of dose and blur in order to account for measurement noise and ensure that the isofocal dose is contained in the range of dose variations. The individual sub-patterns are spaced apart by a distance $D$. This distance $D$ will, suitably, be at least 3 times the maximal backscattering range (e.g. $D = 30$ μm), so as to avoid mutual interaction of the sub-patterns (ideally, depending on total pattern density, even greater values of $D$ may be preferred in order to account for long-range interactions such as the fogging effect). In one favored embodiment of the invention, which utilizes a MBMW of the applicant as described above for exposure, additional provisions will ensure that the pattern to be measured (in particular the center line) is exposed by the same part of the beam field in every sub-pattern, in order to ensure uniform exposure blur, which otherwise could vary across the beam field). This can be provided for, for instance, by choosing the size and mutual distance of the sub-patterns to be an integer multiple of the size of the beam field.

Without loss of generality, we stipulate the lines to be oriented along the y-direction ("vertically" in the drawings) in the embodiments of the invention discussed here and below.

Isofocal dose

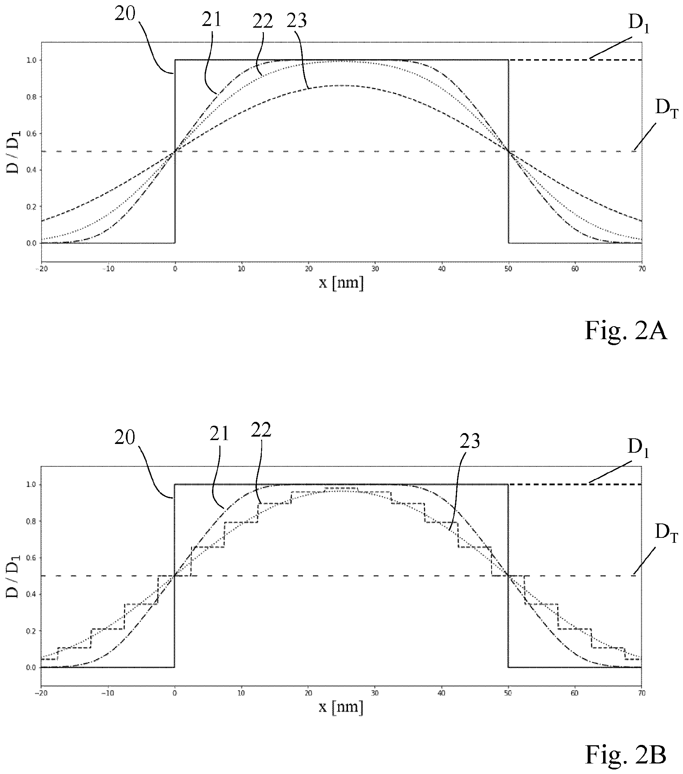

The concept of isofocal dose is explained with reference to Fig. 2A in this section. This concept is based on the realization of a binary pattern, using a threshold model to model the relationship between dose profile (i.e. the absorbed energy density in the resist) and generated pattern shape. Accordingly, those parts of the exposed dose profile that have a dose above the dose threshold remain after resist processing, and the other parts will be removed during resist processing (positive resist; for a negative resist the situation is inverted). For an arbitrary pattern, the generated dose profile will, in general, depend on the blur of the beam used for exposure. Referring to Fig. 2A, for instance, a 50 nm line with ideal dose profile 20 is exposed, the figure shows the emerging profiles for beam blurs with standard deviations of 4 nm (profile 21), 8 nm (22) and 16 nm (23). If the dose $D_1$ assigned to the line is chosen to be twice the threshold dose $D_T$ of the resist, i.e. $D_1 = 2D_T$, the exposed width is normally independent of the beam blur - and therefore "isofocal", i.e., invariant with focal changes of the optical imaging system. Note that the values of the exposure dose D are normalized to $D_1$ in the drawing. For an exposure, doses would have to be adjusted for backscattering, which is disregarded in Fig. 2A for simplicity. It should further be noted that for feature sizes in the order of standard deviation the beam blur, such behavior is generally only possible for certain types of patterns (e.g. lines and spaces of equal width). Also, for a physical resist with an imperfect contrast curve, isofocality is only approximately possible, since the developed and etched shapes typically depends on the blur-dependent dose profile slope.

In US 9,520,268 and US 9,373,482, in the context of a charged-particle multi-beam mask writer, the applicant introduced a technique to emulate physical beam blur by adjustment of the exposure pattern. Using this method, as illustrated in Fig. 2B, an ideal dose profile 20 is adjusted by convolution with a pixel-based kernel to obtain a modified exposure pattern 22 (the steps in the profile 22 are smoothed out by virtue of the finite blur). Exposed with a physical blur of 4nm standard deviation, the modified pattern generates a flatter dose profile 23 (corresponding to a higher blur) as compared to the dose profile 21 generated by the original pattern. It is to be noted that when the pattern is exposed with an isofocal dose, the exposed line width is again invariant with respect to emulated blur (in particular, the exposed dose profiles 21 and 23 both intersect at the dose threshold $D_T$).

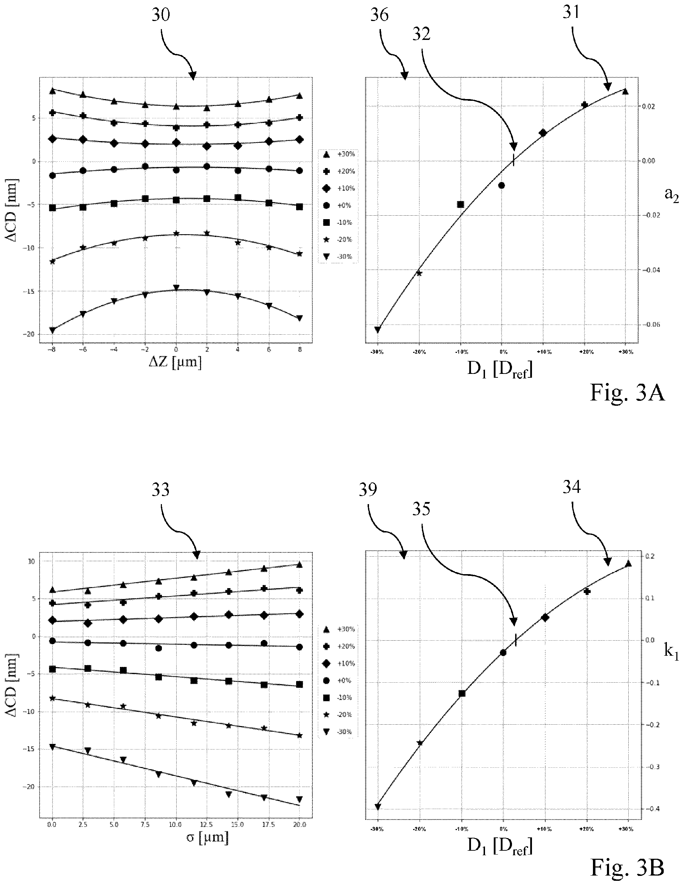

One suitable procedure for determining, experimentally, the isofocal dose for a given pattern or sub-pattern (which often will also depend on the pattern density) uses so-called "Bossung plots", which plot the variation of CD, against change of blur for a plurality of candidate dose values. The procedure is explained with reference to Fig. 3A. The pattern of interest is exposed and measured multiple times, with varying dose levels between -30% and +30% relative to a reference dose level, while varying the height of beam focus, as the variation of height of beam focus causes a corresponding change in beam blur. The height of beam focus is denoted in Fig. 3A in terms of a relative value $\Delta Z$ with respect to the Z-position of the target plane (or another standard position on the Z-coordinate), and is varied through a suitable range, e.g. $\pm 8\,\mu m$. The resulting multiple CD values -in Fig. 3A denoted as relative values $\Delta CD$ with respect to an arbitrarily chosen reference value of CD- are evaluated using a presentation as shown in the plot 30, where different markers indicate different dose levels; evidently, the response to a change in beam blur will depend on the chosen dose level. The dose level $D_1$ is denoted in Figs. 3A and 3B in terms of relative variation with respect to a standard dose level $D_{ref}$, so a dose level equal to $D_{ref}$ corresponds to "+0%"; the standard dose level $D_{ref}$ is chosen arbitrarily, e.g. at the double of an estimate of the does threshold, $D_{ref} = 2D_T^{(estim)}$. Further, second-order polynomials are fit to the measured CD values for each fixed dose level, shown as curves in plot 30. The curvatures (i.e., coefficient $a_2$ of the quadratic term, symbolically $a_2 = d^2(\Delta CD)/d(\Delta Z)^2$) of the polynomials of the curves of plot 30 are evaluated, the curvature values $a_2$ are inserted in a plot 36 as function of the dose level $D_1$. To determine the dose with minimal variance under change of focus, a second regression curve 31 is determined, as graphed in plot 36. At the position 32 of sign change of the regression curve, the curvature $a_2$ is expected to be 0; this position may be called location of "stationary parameters", and the dose at this position 32 is the isofocal dose (in the example shown at +3% relative to reference dose, i.e. $D_{isf} = 1.03\ D_{ref}$).

The procedure described above may also be performed with emulated pixel-based blur instead of physical beam blur, as illustrated in Fig. 3B. As in the method described referring to Fig. 3A, the pattern is exposed and measured with the dose $D_1$ varied between -30% and +30% for several levels of blur; however, the blur variation is generated by adjusting the pattern by convolution with Gaussian kernels of increasing width (pixel-blur having standard deviation $\sigma$). In the plot 33, the data points are augmented with regression lines to determine the values of slope ki (symbolically $k_1 = d(\Delta CD)/d\sigma$). The slope $a_1$ is plotted against the dose level assigned in the plot 39, and a regression curve 34 of the slope values is determined. To obtain the isofocal dose 35, the position of sign change of the regression curve 34 as location of "stationary parameters" is determined (in the example shown, again, at +3% relative to reference).

It is to be noted that, generally, there are further parameters which may influence the value of the isofocal dose, such as the pattern density, which may be expressed or simulated by means of a suitable control width of test patterns. Thus, the Bossung plots of Figs. 3A and 3B will vary slightly when such further parameters are varied, and the location of stationary parameters will vary accordingly as a function of the various parameters, as a "stationary parameter course".

The inventors found that it is often advantageous because of reduced complexity to use global dose modulations for the above, so a "global" isofocal dose is determined, i.e. the whole sub-patterns including the background generating features are exposed at a constant dose level (so the dose background due to backscattering also scales with the chosen dose level). Variations of the described method may also determine "local" isofocal doses, in which only the dose at the edge of the feature of interest is modulated; this change, however, has to be accounted for in the post-processing steps as further discussed below.

Point spread functions

In most embodiments, the invention starts from assuming that an imaging transfer function such as a point-spread function, which is to be determined by the invention, is rotationally symmetric and comprises forward- and back-scattering components, that is

$$F(r) = F_f(r) + F_b(r). \tag{1}$$

In many embodiments corresponding a typical use-case of the invention, a Multi-Gaussian PSF is determined. Then, we have

$$F_f(r) = \frac{1}{1 + \sum v_k} G_\alpha(r)$$

$$F_b(r) = \frac{1}{1 + \sum v_k} \sum_{k=1}^{K} v_k \, G_{\gamma_k}(r) \tag{2}$$

$$G_\omega(r) = \frac{1}{\pi \omega^2} \exp\left(-\frac{r^2}{\omega^2}\right)$$

for Gaussians with weights $v_1, ..., v_K$ and ranges $\gamma_1, ..., \gamma_K$, which, alongside the forward scattering range $\alpha$, are the unknown parameters (summarized under the symbol $C$) of the point spread function. The integral of the PSF over the target area is normalized to 1. Furthermore, the forward-scattering weight is fixed to 1, and thus it corresponds to the D50-dose for lines and spaces of equal width (50% pattern density), which is independent of blur, width and spacing. The D50-dose is usually determined separately and then used to normalize other dose values after measurement to obtain relative doses. For instance, the D50-dose may be determined by including lines and spaces of equal width (or other suitable features of uniform width) in the test pattern and performing a determining procedure for the isofocal dose as described above based on the corresponding CD measurements.

The method of the invention can also be utilized to determine point spread functions defined by a piecewise polynomial of the radius, for instance, a cubic spline PSF. The use of point spread functions of this type for proximity effect correction has been suggested, e.g. in US 10,553,394. For least-squares fitting purposes, the use of B-Splines (a set of Basis functions for a given space of spline functions) is favorable. B-Splines are readily constructed with routines in standard numerical libraries, such as *scipy* or *PPPACK*. Splines and B-Splines may be used to model PSF functions that are more general than Gaussians or Multi-Gaussians. To define a spline basis $B_1, ..., B_K$ of polynomial degree M basis with $K = L - M - 1$ degree of freedom one first determines a set $R$ of radial grid points $r_1 \leq r_2 \leq \cdots \leq r_L$. Sufficiently, the grid points are chosen uniformly spaced (cardinal B-Splines) with their knots lying in the range of the point spread function of interest (outside it is zero). The B-Spline functions are combined with a weighted sum

$$S_C^R(r) = \sum_{k=1}^{K} c_k B_k^R(r) \tag{3}$$

where the coefficients $C = (c_1, ..., c_K)$ are PSF parameters, to form a PSF component.

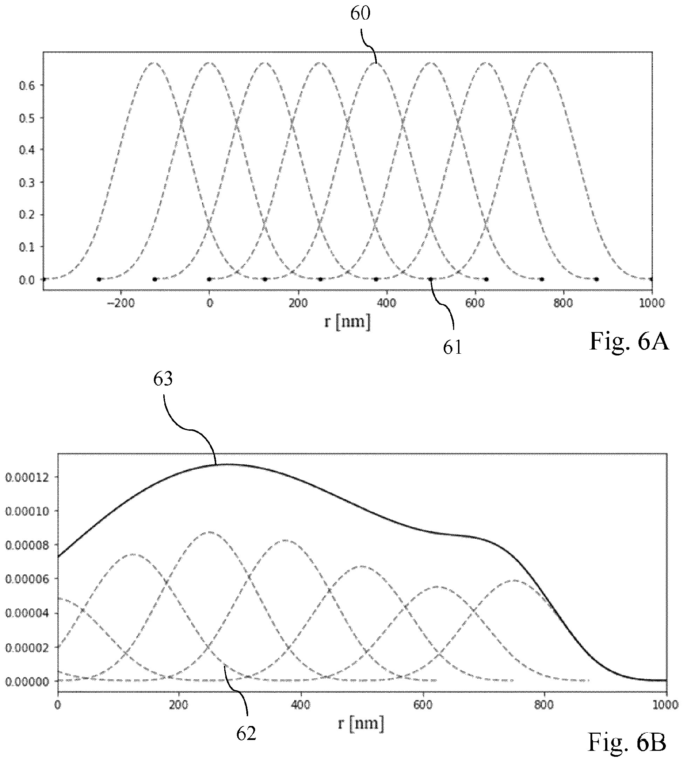

Fig. 6A shows an exemplary set of 8 cardinal cubic B-Splines 60 with 12 grid points 61 (i.e. $K = 8$, $L = 12$, $M = 3$). Fig. 6B depicts an example illustrating how the spline functions 62 can be combined with a weighted sum to fit an arbitrary radial function 63, which decays outside the interval defined by the grid points. Spline functions of this type can be used to model arbitrary PSF behavior.

To form a full PSF, multiple spline components of the above type with individual grids can be combined by summation and normalizing the integral to 1. For instance, a fine grid $R_f$ (and coefficients $C_f$) for the forward scattering component $S_{C_f}^{R_f}$ (with weight normalized to 1) and a coarse grid $R_b$ (and coefficients $C_b$) for the backscattering component $S_{C_b}^{R_b}$ (with arbitrary positive weight) may be given by

$$F(r) = \frac{1}{1 + \omega\left(S_{C_b}^{R_b}\right)}\left(\frac{S_{C_f}^{R_f}(r)}{\omega\left(S_{C_f}^{R_f}\right)} + S_{C_b}^{R_b}(r)\right). \tag{4}$$

Here, $\omega(S) = \int_{\mathbb{R}^2} S\, d\vec{x}$ denotes the weight of a spline component, C = (C_f, C_m, C_b) is the vector of combined PSF coefficients. Multi-Gaussian and Spline PSFs can also be combined to form composite point spread functions, e.g. using Gaussians components $G_\alpha$, $G_\beta$ for forward and long-range backscattering (with weights 1 and $\eta$) and a spline component $S_{C_m}^{R_m}$ for mid-range backscattering in the 200-2000nm range, leading to

$$F(r) = \frac{1}{1 + \eta + \omega\left(S_{C_m}^{R_m}\right)}\left(G_\alpha(r) + \eta G_\beta(r) + S_{C_m}^{R_m}(r)\right) \tag{5}$$

with parametrization $C = (\alpha, \beta, \eta, C_m)$.

In some embodiments of the invention, parts of some type of point spread function (or, equivalently, some its parameters) may be known already (e.g. the backscattering range $\beta$) or turn out to be not recoverable (independent) from the measured range of isofocal doses (e.g. the forward scattering range $\alpha$, which only modulates the isofocal dose for very small control widths $w_k < 2\alpha$). In such a case, it is generally a sufficient approach to insert values that are known from experiment or literature, as the skilled person will deem appropriate, and continue the procedure with these inserted values.

Numerical isofocal dose

Using an exposure model such as the threshold model mentioned above, it is possible to determine the isofocal dose for a given point spread function and sub-pattern, which can then be matched with the measured isofocal doses. For a threshold exposure model, the exposed dose profile $d(x, y)$ may be simulated by convolution

$$d(x,y) = (P * F)(x,y) = \int_{-\infty}^{\infty}\int_{-\infty}^{\infty} P(x-t, y-s)F(t,s)\, ds\, dt \tag{6}$$

of the binary indicator function of the sub-pattern P (which is 1 if in the pattern and 0 if not) with the PSF denoted as F. For the patterns presented above (see Figs. 5A-5D), which use vertical pattern lines only, the above integral can be reduced to one dimension, giving

$$d(x) = (p * f)(x) = \int_{-\infty}^{\infty} p(x-t)f(t)\, dt \tag{7}$$

where $f = \int_{-\infty}^{\infty} F\, dy$ (also called marginal point spread function) and $p(x) = P(x, y_0)$ is the one-dimensional pattern in x-direction with fixed arbitrary $y_0$. For a Multi-Gaussian PSF, the marginal point spread function is a one-dimensional Multi-Gaussian; for a spline or composite PSF, the marginal PSF can be determined numerically (e.g. by numerical integration).

The continuous convolution of eq. (6) may suitably be approximated by a discrete convolution of samples of the functions p and F in a sufficiently fine computational grid, e.g. with 0.1nm resolution. The computation should, suitably, be performed over at least 3 times the maximum range of the point spread function (for a Multi-Gaussian) or over the support of a spline function.

In the threshold model, the isofocal dose $D_{isf}$ can then be determined by choosing the dose under which the measured structure width varies the least under blur fluctuations, that is,

$$D_{isf} = \arg\min_{D} \mathrm{Var}_{\alpha \in A} \mathcal{M}(D \cdot (p * f_\alpha)) \qquad (8)$$

where $f_\alpha$ is the marginal PSF with variable forward scattering range (e.g. taken in the set of test blurs A, which were also applied experimentally to the test pattern), and $\mathcal{M}$ is a symbol for evaluating the convoluted pattern $(p * f_\alpha)$ to determine the area or width of the structure feature that is exposed when the exposure dose $D$ is applied to the relevant sub-pattern. For instance, in terms of a threshold model, the evaluation $\mathcal{M}$ will yield the dimension (area or width) of those portions of the exposed structure that are at doses above the dose threshold $D_T$. The minimum (dose of least variation) can be determined over a set of candidate doses either by numerical minimization or direct calculation.

Analytical evaluation of isofocal dose

In some cases, it is possible to calculate the isofocal dose $D_{isf}$ for the (one-dimensional) sub-pattern $p$ analytically from the marginal PSF $f$ without having to calculate multiple exposure dose profiles by convolution (which is typically slow). To do so, in a first step, the dose background (for unit dose) at the line edge $x_e$ (which edge does not matter due to the left/right symmetry of the test pattern) of the feature of interest (e.g. isoline 51 or central line width of line triple 52, 53) is calculated by

$$b(x_e) = (p * f)(x_e) = \int_{\mathcal{P}} f_b(t - x_e)dt. \qquad (9)$$

that is, by integrating the backscattering part $f_b = \int_{-\infty}^{\infty} F_b dy$ of the marginal point spread function $f$, localized at the pattern edge, over the pattern $\mathcal{P}$. For a generic point spread function, this calculation can be suitably performed on a computer by choosing a set of uniform grid points, summing sampled function values for grid points in the pattern, and multiplying with the grid step (or by other types of numerical integration).

For some types of PSFs a test pattern (9) can be evaluated using "standard" functions. For a Multi-Gaussian PSF (2) and isolines 51 as test pattern, for instance, we have

$$b(x_e) = \frac{1}{1 + \sum_k v_k} \sum_k \frac{v_k}{2} \, \mathrm{erf}\left(\frac{w}{\gamma_k}\right), \qquad (10)$$

where erf is the Gauss error function.

In a second step, the isofocal dose is determined from the dose background. For lines of width w that are large relative to the forward scattering range (e.g. $3\alpha < w$ for a Multi-Gaussian PSF), it is well known (compare, e.g. M. Yu et al in Proc. SPIE 5853, Photomask and Next-Generation Lithography Mask Technology XII, available at https://doi.org/10.1117/12.617058) that the isofocal dose $D_{isf}$ at the line edge $x_e$ is given by

$$D_{isf} = D_0 \cdot \left(1 - 2B(x_e)\right) \qquad (11)$$

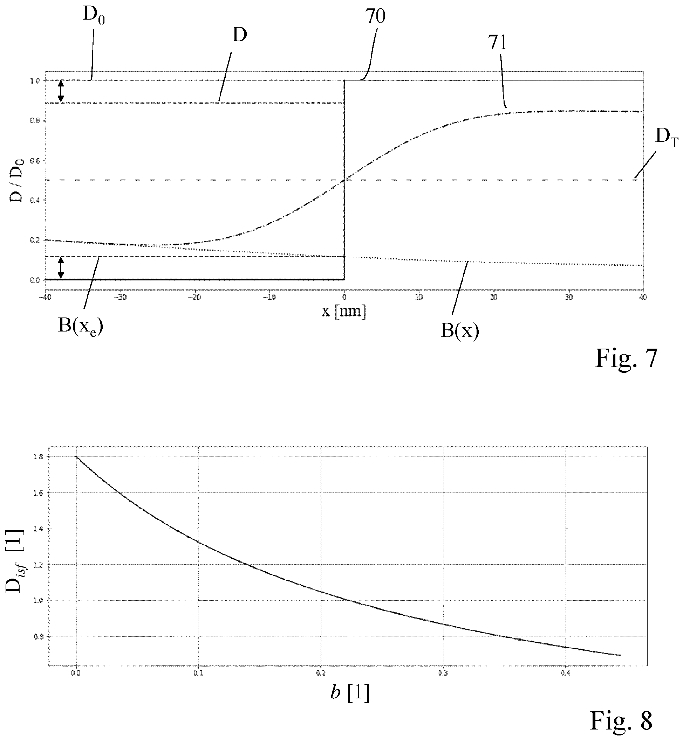

in the threshold model, which is illustrated in Fig. 7 for a 100nm line 70. Here, $D_0$ is the so-called iso-dose, that is, the isofocal dose for isolated features (without dose background) and B is the (absolute) dose background. The correction factor $(1 - 2B(x_e))$ is chosen such that the intersection of the exposed dose profile 71 with the dose threshold $D_T$ remains at half the dose in the presence of background. Since the dose background $B$ also scales with the isofocal dose (assuming it is determined globally),

$$D_{isf} = D_0 \cdot \left(1 - 2D_{isf}b(x_e)\right), \qquad (12)$$

so the isofocal dose $D_{isf}$ can be determined from the unit dose background b with

$$D_{isf}(b) = \frac{D_0}{2bD_0 + 1}, \qquad (13)$$

compare the graph in Fig. 8 (for $D_0$ = 1.8). The inverse is given by

$$b(D_{isf}) = \frac{1}{2}\left(\frac{1}{D_{isf}} - \frac{1}{D_0}\right). \qquad (14)$$

Inverse problem

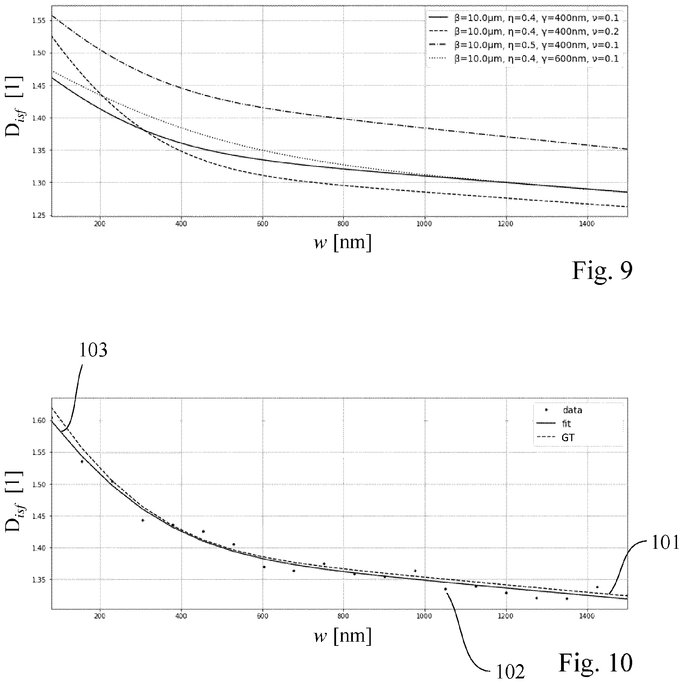

The existence of an isofocal dose for a range of sub-patterns with variable control widths is a "signature" property of the point spread function, which allows its determination by solving an inverse problem. For a Multi-Gaussian PSF, for instance, each parameter uniquely changes the shape of the isofocal dose trend. This is illustrated in Fig. 9, which shows values determined for isolated lines in a range of 80-1500nm of line width $w$ and four sets of parameters for a Triple-Gaussian model $F_{MG3}$ with parameters $\beta, \eta$ (long-range Gaussian weight and range) and $\gamma, \nu$ (mid-range Gaussian weight and range). In this example, the forward scattering range $\alpha$ is not of relevance since it does not influence the isofocal dose in the selected range of line widths.

The simulation approach of eq. (8), or alternatively the combination of the formulas (9) and (13), allows the determination of the isofocal dose

$$D_{isf}(F, w) = D_{isf}(C, w) \qquad (15)$$

as a function of the given PSF $F$ or its coefficients $C$ (or a subset thereof, if they are partially known or cannot be determined from the measurement range) and sub-pattern control width w (such as one of the widths $w_1, ..., w_N$ of Figs. 5A to 5B).

This forward measurement function can be formally inverted to estimate the PSF coefficients $C_{est}$ from measured isofocal doses $\hat{D}_{w1}, ..., \hat{D}_{wN}$ corresponding to sub-patterns with control widths $w_1, ..., w_N$. In a favorable embodiment of the invention, a non-linear least-squares fit is utilized for this purpose, that is

$$C_{est} = \underset{C}{\mathrm{argmin}} \sum_{n=1}^{N} \left| D_{isf}(C, w) - \hat{D}_{w_n} \right|^2. \qquad (16)$$

To increase the stability of the fit procedure in the presence of noise (or if insufficiently many measurements are available), it may be advantageous to augment eq. (16) using a suitable regularization term, for instance of L1/L2-type

$$C_{est} = \underset{C}{\mathrm{argmin}} \sum_{n=1}^{N} \left| D_{isf}(C, w) - \hat{D}_{w_n} \right|^2 + \lambda |s \cdot C|^p \qquad (17)$$

where e.g. $p$ = 1 ("Lasso regularization") or $p$ = 2 ("Tikhonov regularization"), $\lambda$ is a regularization parameter which determines the amount of regularization, and s a selection vector which chooses which PSF coefficients are regularized (e.g. weights only). If there are large number of parameters in the PSF model, Lasso regularization will usually be advantageous, since the regularization term typically forces the least significant parameters to be 0, so unweighted terms can be removed from the model.

A different variant penalizes variation or curvature of the point spread function F with

$$C_{est} = \underset{C}{\mathrm{argmin}} \sum_{n=1}^{N} \left| D(C, w) - \hat{D}_{w_n} \right|^2 + \lambda \left| \frac{\partial^m}{\partial r^m} F(C) \right|^2, \qquad (18)$$

where $m$ = 1 or 2. This variant approach may be useful to avoid overfitting to measurement noise.

The minimization prescriptions (16), (17), (18) above are readily performed by state-of-the-art numerical packages such as the routines included in *scipy* (using least-squares routines or general purpose minimization methods).

An example of the fitting procedure is shown in Fig. 10. Starting from a hypothetical example of an initial PSF which is a Multi-Gaussian having parameters $\beta$ = 10$\mu$m, $\eta$ = 0.5, $\gamma$ = 400nm, $\nu$ = 0.2, an isofocal dose trend 101 for 20 isolated lines in a range of 80-1500nm of line width $w$ was generated, as indicated by the dashed line (denoted GT for "ground truth"), and artificial noise was added, in order to obtain a set of data points 102. Based on these data points 102, a fit 103 was made, which produced reconstructed parameters $\beta = 9.8\mu m$, $\eta = 0.49$, $\gamma = 425nm$, $\nu = 0.18$ corresponding to the fitted trend 103. These reconstructed parameters (full line) are within 10% of the initial PSF parameters. This demonstrates the high ability of the invention to reproduce parameters of an imaging transfer function.

**Claims**

1. A method for determining an imaging transfer function of a charged-particle exposure apparatus during exposure of a target positioned in a target plane of said apparatus, said imaging transfer function describing the distribution of dose or energy generated at the target plane resulting from a single active element in a pattern definition device of the charged-particle exposure apparatus when said single active element is imaged to a substrate in the charged-particle exposure apparatus,
the method comprising the steps of

    i. providing a model of the imaging transfer function, said model including at least one function parameter to be determined,
    ii. selecting a set of imaging properties, including at least one of a beam blur and a beam focus, which are adjustable through modifying pre-defined imaging parameters of the charged-particle apparatus, other than a base exposure dose describing an overall intensity of the imaging transfer function;
    iii. exposing, using the exposure apparatus, a test substrate with a test pattern and developing the test substrate to produce a test structure on said at least one test substrate,

        wherein the test pattern comprises a plurality of sub-patterns each of which is a copy of a sub-pattern template modified according to at least one control parameter, said at least one control parameter varying across the sub-patterns of the plurality of sub-patterns within a defined parameter range, and
        wherein the test pattern is exposed to the test substrate a number of times with the base exposure dose and at least one imaging parameter of the charged-particle apparatus being varied, to produce a number of test pattern copies on the substrate,

    the test structure thus produced comprising a plurality of sub-structures, each sub-structure being associated with specific values of imaging parameters, the base exposure dose, and said at least one control parameter;
    iv. evaluating the sub-structures with respect to at least one measurable quantity, including a critical dimension of features in the sub-structure;
    v. determining, for each value of the at least one control parameter, the variation of said at least one measurable quantity between the sub-structures as a function of the imaging parameters, and determining, from said variation, a respective value of isofocal dose where the variation is minimally variant with respect to the changes in the imaging parameters,
    vi. calculating, using the values of isofocal dose determined in step v as function of the at least one control parameter the at least one function parameter of the imaging transfer function.

2. The method of claim 1, wherein the measurable quantity in steps iv and v includes a critical dimension of a feature of interest in the sub-structures.

3. The method of any one of the preceding claims, wherein the imaging transfer function is modeled as weighted sum of radially symmetric Multi-Gaussian functions, said sum including at least three Gaussian components as summands, and in step vi the weights and/or length scales of at least one of said summands are determined.

4. The method of claim 3, wherein the imaging transfer function includes a Multi-Gaussian function comprising at least one mid-range component having a weight and a length scale as parameters that are determined in step vi, wherein the length scale corresponds to a width constrained to a range between 200nm and $2\mu m$.

5. The method of any one of the preceding claims, wherein the method further includes a step of

    ii'. calculating, in terms of the model provided in step i and the at least one function parameter thereof, a model calculation of said at least one measurable quantity as a function of said subset of the imaging and control parameters and determining the values of the parameters of said subset where said model calculation predicts said at least one measurable quantity to be stationary with respect to said parameters,

which step ii' is performed before step vi, and
step vi includes performing a least-squares fit of said model calculation to a course of minimal variation to obtain final parameters of the imaging transfer function.

6. The method of claim 5, wherein the fitting in step v is performed by finding an optimal value of an evaluation function including a weighted sum of squares of differences between the values of parameters in the model calculation and the course of minimal variation.

7. The method of claim 6, wherein the evaluation function is augmented with a regularization term, said regularization term including the first and/or second radial derivatives of the imaging transfer function and/or the magnitude (L2) or sum of absolute values of a vector of imaging transfer functions (L1).

8. The method of any one of the preceding claims, wherein different values of beam blur are generated by physically defocusing the beam by means of modulation of appropriate electrostatic voltages of lens and/or multi-pole lens components of an imaging system of the charged-particle exposure apparatus.

9. The method of any one of the preceding claims, wherein different values of beam blur are generated by modulating the pattern to emulate an increased blur.

10. The method of any one of the preceding claims, wherein the sub-pattern template is selected from one of the following:

   a single line, wherein the control parameter is the width of line;
   a triple line structure comprising a center line surrounded by two outer lines, wherein the control parameter is the width of the two outer lines;
   a triple line structure comprising a center line surrounded by two outer lines, wherein the control parameter is the distance of the two outer lines from the center line;
   or a combination of thereof,

   and the measurable quantity in the resulting sub-structure is the width of the single line or center line, respectively.

11. An exposed substrate comprising a test structure on at least one test substrate exposed in a charged-particle exposure apparatus according to steps i to iii of the method of any one of the preceding claims, the test structure comprising a plurality of sub-structures, said sub-structures being formed using copies of the same underlying sub-pattern template modified according to a control parameter varying across the sub-patterns.

12. The substrate of claim 11, further comprising multiple sub-structures which have been formed in said charged-particle exposure apparatus by applying respective values of imaging parameters, said values being different between each of said multiple sub-structures.

13. The substrate of claim 11 or 12, wherein the underlying sub-pattern template comprises one of the following:

   a single line, wherein the control parameter is the width of line;
   a triple line structure comprising a center line surrounded by two outer lines, wherein the control parameter is the width of the two outer lines;
   a triple line structure comprising a center line surrounded by two outer lines, wherein the control parameter is the distance of the two outer lines from the center line;
   or a combination of thereof,

   and the measurable quantity in the resulting sub-structure is the width of the single line or center line, respectively.

Fig. 1

Fig. 2A

Fig. 2B

Fig. 3A

Fig. 3B

```
┌─────────────────────┐
│        MDL          │
└─────────────────────┘
           │
           ▼
┌─────────────────────┐
│        EXP          │
└─────────────────────┘
           │
           ▼
┌─────────────────────┐
│        MCD          │
└─────────────────────┘
           │
           ▼
┌─────────────────────┐
│        IFD          │
└─────────────────────┘
           │
           ▼
┌─────────────────────┐
│        FIT          │
└─────────────────────┘
```

Fig. 4

Fig. 5A

Fig. 5B

Fig. 5C

Fig. 5D

Fig. 6A

Fig. 6B

Fig. 7

Fig. 8

Fig. 9

Fig. 10

## EUROPEAN SEARCH REPORT

Europäisches
Patentamt
European
Patent Office
Office européen
des brevets

**Application Number**

EP 24 18 3046

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KEIL K ET AL: "Resolution and total blur: Correlation and focus dependencies in e-beam lithography", JOURNAL OF VACUUM SCIENCE AND TECHNOLOGY: PART B, AVS / AIP, MELVILLE, NEW YORK, NY, US, vol. 27, no. 6, 2 December 2009 (2009-12-02), pages 2722-2726, XP012129559, ISSN: 1071-1023, DOI: 10.1116/1.3246365 * abstract * * page 2723 - page 2726; figures 2,4,6 * | 1-13 | INV. H01J37/304 H01J37/317 |
| X | LOPEZ GERALD G ET AL: "Isofocal dose based proximity effect correction tolerance to the effective process blur", JOURNAL OF VACUUM SCIENCE, AMERICAN INSTITUTE OF PHYSICS, 2 HUNTINGTON QUADRANGLE, MELVILLE, NY 11747, vol. 35, no. 6, 21 November 2017 (2017-11-21), XP012223871, ISSN: 2166-2746, DOI: 10.1116/1.4995421 [retrieved on 2017-11-21] * page 2 - page 8; figures * | 1-13 | |

TECHNICAL FIELDS SEARCHED (IPC)

H01J

The present search report has been drawn up for all claims

| Place of search | Date of completion of the search | Examiner |
|---|---|---|
| Munich | 14 November 2024 | Krauss, Jan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 9520268 B
- US 6768125 B
- US 8222621 B
- US 8378320 B
- US 5241185 A
- US 6815693 B
- US 7511290 B
- US 9373482 B
- US 10553394 B

### Non-patent literature cited in the description

- **H. TANABE et al.** Photomask and Next-Generation Lithography Mask Technology XVII. *Proc. SPIE*, vol. 7748, 774823, https://doi.org/10.1117/12.862641
- **P. HUDEK et al.** *J. Micro/Nanopattern. Mats. Metro.*, vol. 20 (4), 041402, https://doi.org/10.1117/1. JMM.20.4.041402
- **K. KEIL et al.** *Microelectronic Engineering*, vol. 85 (5-6), 778-781, https://doi.org/10.1016/j. mee.2008.01.042
- **M. YU et al.** Photomask and Next-Generation Lithography Mask Technology. *Proc. SPIE 5853*, vol. XII, https://doi.org/10.1117/12.617058